Europäisches Patentamt

European Patent Office

Office européen des brevets

(11) Veröffentlichungsnummer: **0 254 910 B1**

(19)

(12) # EUROPÄISCHE PATENTSCHRIFT

(45) Veröffentlichungstag der Patentschrift: **30.09.92**

(21) Anmeldenummer: **87109652.5**

(22) Anmeldetag: **04.07.87**

(51) Int. Cl.⁵: **H01L 23/48**

(54) **Druckkontaktierter GTO-Thyristor.**

(30) Priorität: **30.07.86 CH 3049/86**

(43) Veröffentlichungstag der Anmeldung:
**03.02.88 Patentblatt 88/05**

(45) Bekanntmachung des Hinweises auf die
Patenterteilung:
**30.09.92 Patentblatt 92/40**

(84) Benannte Vertragsstaaten:
**BE CH DE FR GB IT LI SE**

(56) Entgegenhaltungen:
EP-A- 0 064 231  EP-A- 0 345 435
EP-A- 0 355 359  DE-A- 2 821 268
DE-A- 3 009 511  DE-A- 3 723 150
FR-A- 1 446 767  FR-A- 2 207 358
US-A- 4 127 863  US-A- 4 402 004
US-A- 4 556 898

**Proceedings of 1990 Intnl. Symposium on
Power Semiconductor Devices & ICS Tokyo
pp.240 245**

(73) Patentinhaber: **BBC Brown Boveri Aktiengesellschaft**

**CH-5401 Baden(CH)**

(72) Erfinder: **Jaecklin, André, Dr.
Geissbergstrasse 55
CH-5400 Ennetbaden(CH)**
Erfinder: **Pakoczy, Tibor
Lindenhof 22
CH-5430 Wettingen(CH)**
Erfinder: **Zimmermann, Wolfgang, Dr.
Rottrottenweg 24
CH-5313 Klingnau(CH)**

**Beschreibung**

TECHNISCHES GEBIET

Die Erfindung bezieht sich auf einen druckkontaktierten GTO-Thyristor.

Sie betrifft insbesondere einen solchen Thyristor mit einer Halbleiterscheibe mit einer Folge unterschiedlich dotierter Schichten, die zwischen einer Kathodenseite und einer Anodenseite angeordnet sind, wobei die Halbleiterscheibe zumindest kathodenseitig stufenförmig ausgebildet ist und eine Gate-Kathoden-Struktur aufweist mit einer Mehrzahl von erhabenen Kathodenfingern, welche von einem tieferliegenden Gatebereich umgeben sind, und wobei die Halbleiterscheibe auf den Kathodenfingern jeweils mit einer metallischen Kathodenschicht und anodenseitig mit einer metallischen Anodenschicht belegt ist; und mit einem scheibenförmigen kathodenseitigen und anodenseitigen Druckkontakt, welche zur Kontaktierung auf die Kathodenschichten bzw. Anodenschichten gepresst werden.

STAND DER TECHNIK

Die zunehmende Verbreitung der Leistungselektronik in der Energieübertragung und -steuerung oder in elektrischen Antrieben hat zu der Entwicklung von immer leistungsfähigeren Leistungshalbleitern, insbesondere Dioden und Thyristoren, geführt, die mit immer grösseren Durchmessern der Halbleiterscheiben eine steigende Stromtragfähigkeit und steigende Sperrspannungen aufweisen. Die Probleme bei der Herstellung solcher hochbelastbarer Leistungshalbleiter liegen nicht allein in der Präparation der Halbleiterscheibe selber, sondern vor allem auch beim Einbau der Scheibe in ein geeignetes Gehäuse.

Bei diesem Einbau muss nicht nur auf guten elektrischen und thermischen Kontakt zwischen Halbleiterscheibe und Umgebung geachtet werden, sondern auch auf eine ausreichende Lastwechselfestigkeit, d.h. auf einen ausreichenden Schutz des eingebauten Elements gegen Ermüdung bei wechselnder Belastung. Besondere Bedeutung kommt hierbei der Kontaktierung der Halbleiterscheibe innerhalb des Gehäuses zu.

Es ist nun seit langem bekannt, für Leistungshalbleiter den sogenannten "legierten Druckkontakt" zu verwenden (siehe z.B. J.Knobloch, S.Prough, "Solderless Construction of large Diameter Silicon Power Devices", Proc. IAS Conf.1977), bei dem die Halbleiterscheibe einseitig mittels eines speziellen Lotes (z.B. einer Aluminium-Legierung) auf eine Metallunterlage (z.B. aus Mo oder W) gelötet und von der anderen Seite mit einer aufgepressten Metallscheibe druckkontaktiert wird.

Die durch das Löten erzeugte Halbleiter-Metall-Schichtstruktur führt wegen der nicht vernachlässigbaren Unterschiede in den thermischen Ausdehnungskoeffizienten bei den wachsenden Durchmessern der Halbleiterscheiben zu grösser werdenden mechanischen Biegespannungen, welche die Lastwechselfestigkeit des Bauelements nachhaltig verschlechtern.

Man ist daher dazu übergegangen, bei herkömmlichen Thyristoren und Dioden den legierten Druckkontakt durch den sogenannten "direkten Druckkontakt" zu ersetzen, bei dem die Halbleiterscheibe von beiden Seiten durch angepresste Metallscheiben druckkontaktiert wird (siehe z.b. den o.g. Artikel von J.Knobloch et al. oder Brown Boveri Mitt. 1 (1979), S. 5-10).

Diese Art der Kontaktierung hat sich bei herkömmlichen Thyristoren, die eine Halbleiterscheibe mit beidseitig planaren Oberflächen aufweisen, bewährt, da hier wegen der Planarität eine ausreichend homogene Druckverteilung innerhalb der Halbleiterscheibe gewährleistet ist.

Anders ist die Situation jedoch bei den abschaltbaren GTO (Gate Turn Off)-Thyristoren mit stufenartiger Gate-Kathoden-Struktur (siehe z.B. die US-PS 4 127 863), bei denen auf der Kathodenseite für die Druckkontaktierung nur noch die Mehrzahl der erhabenen Kathodenfinger zur Verfügung stehen, die mit ihrer insgesamt kleineren Fläche einen höheren Druck aufnehmen und möglichst gleichmässig in das Volumen der Halbleiterscheibe einleiten müssen.

Aus der DE-OS 27 19 219 (Fig. 6F und zugehörige Beschreibung) ist nun prinzipiell bekannt, den direkten Druckkontakt auch bei einem solchen GTO-Thyristor zu verwenden. Dieser Stand der Technik geht jedoch über das Prinzipielle nicht hinaus und umfasst insbesondere keinerlei Angaben, die eine Realisierung des direkten Druckkontakts unter den beim GTO vorliegenden schwierigen Bedingungen gestatten.

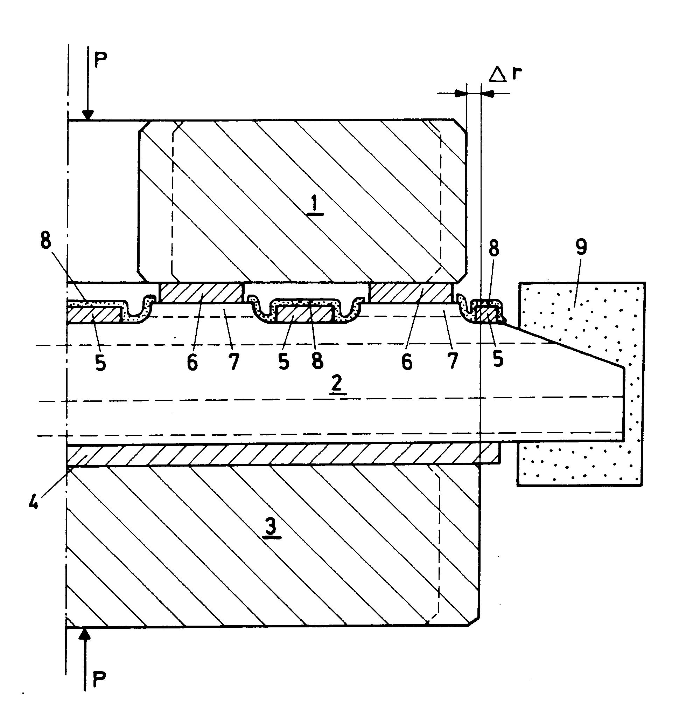

Dass die Bedingungen bei einem GTO mit stufenförmiger Gate-Kathoden-Struktur tatsächlich schwierig sind, lässt sich aus der DE-OS 31 34 074 (S. 20, Zeilen 2-21) entnehmen, wo selbst bei dem dort verwendeten, einfacheren legierten Druckkontakt, bei dem das Halbleitersubstrat 1 auf eine massive, metallische, als Zwischenträger wirkende Anodenplatte 18 auflegiert ist (Fig. 2), die Gatebereiche auf die Höhe der Kathodenfinger gebracht worden sind, um eine Druckentlastung der Kathodenfinger zu erreichen.

Die technologischen Schwierigkeiten mit einem direkten Druckkontakt bei den beschriebenen GTO-Thyristoren haben dazu geführt, dass die bisher kommerziell erhältlichen Hochleistungs-GTOs aussschliesslich mit einem legierten Druckkontakt ausgerüstet sind (siehe z.B. IEEE Transactions On Electron Devices, Vol. ED-28, No.3, März 1981, S.270-274).

## DARSTELLUNG DER ERFINDUNG

Es ist nun Aufgabe der vorliegenden Erfindung, einen druckkontaktierten GTO-Thyristor zu schaffen, der mit einem direkten Druckkontakt ausgerüstet ist und eine ausreichende Lastwechselfestigkeit aufweist.

Die Aufgabe wird bei einem druckkontaktierten Thyristor durch die Gesamtheit der Merkmale aus dem Anspruch 1 gelöst.

Durch das Zusammenwirken dieser Massnahmen wird wirkungsvoll verhindert, dass die am Bauelement auftretenden Lastwechsel über entsprechende mechanische Spannungen die Funktionsfähigkeit des Bauelements beeinträchtigen.

Besonders gute Ergebnisse lassen sich erzielen, wenn die Planitätsabweichungen weniger als ± 1µm und die axiale Abweichung der Mittelachsen weniger als 100 µm betragen.

Da die Druckverteilung mit zunehmendem Durchmesser der Druckkontakte verbessert wird, ist es günstig, Druckkontakte mit einem Durchmesser grösser als 20 mm zu wählen.

Es muss darauf hingewiesen werden, dass alle diese Massnahmen keineswegs im Rahmen des fachmännischen Könnens liegende Dimensionierungen darstellen, sondern dass mit diesen Massnahmen überraschenderweise und entgegen den ursprünglichen Annahmen ein praktisch brauchbarer GTO-Thyristor realisiert werden kann.

## KURZE BESCHREIBUNG DER ZEICHNUNG

Die Erfindung soll nachfolgend anhand von Ausführungsbeispielen im Zusammenhang mit der Zeichnung näher erläutert werden.

Die einzige Figur der Zeichnung zeigt im Querschnitt die Struktur eines GTO-Thyristors mit direktem Druckkontakt, wie sie der Erfindung zugrundeliegt.

## WEGE ZUR AUSFÜHRUNG DER ERFINDUNG

Wie bereits erwähnt, hat sich in der Praxis die Verwendung des direkten Druckkontakts bisher auf Leistungshalbleiter, insbesondere Dioden und Transistoren, mit grossflächigen Kathoden beschränkt, bei denen die angepasste metallische Druckkontakt-Scheibe aus W oder Mo im wesentlichen gleich gross war wie die Kathodenfläche.

Wichtigstes Merkmal war dabei eine einfach zusammenhängende Fläche der Kathode. Im Extremfall waren höchstens einzelne Gräben vorgesehen (z.B. beim sogenannten "Fingergate"), die jedoch nur einen geringen Teil der Kathodenfläche einnahmen. Ueber den Hauptteil der Fläche waren deshalb homogene Druckverhältnisse gewährleistet, sodass allenfalls in den Randbereichen mit geringen, lokalen Drucküberhöhungen gerechnet werden musste.

Beim GTO-Thyristor weist die Halbleiterscheibe nun kathodenseitig eine Vielzahl von länglichen, inselförmigen Kathodenfingern auf, die meist in einer Rosettenstruktur (siehe z.B. Fig. 3 der DE-OS 31 34 074) angeordnet sind. Die anodenseitige Kontaktfläche ist im einfachsten Fall nicht unterteilt, kann aber auch eine Stufenstruktur z.B. in Form verteilter Anodenshorts oder anodenseitiger, tieferliegender Gatebereiche aufweisen.

Ein solcher Thyristor mit planarer Anodenfläche ist in der Figur dargestellt. Zentrales Element der Anordnung ist eine Halbleiterscheibe 2 mit einer Folge von unterschiedlich dotierten Schichten, deren Grenzen in der Figur gestrichelt angedeutet sind.

Kathodenseitig (in der Figur oben) weist die Halbleiterscheibe eine stufenförmige Gate-Kathoden-Struktur auf, in der eine Vielzahl von erhabenen Kathodenfingern 7 von einem tieferliegenden Gatebereich umgeben sind.

Die Kathodenfinger 7 sind mit einer metallischen Kathodenschicht 6, z.B. aus Al, belegt. Auch der dazwischen liegende Gatebereich ist mit einer metallischen Gateelektrode 5 versehen, die entsprechend tiefer liegt als die Kathodenschicht 6.

Anodenseitig (in der Figur unten) ist die Halbleiterscheibe 2 im einfachsten Fall nahezu ganzflächig mit einer Anodenschicht 4, ebenfalls aus Al, belegt. Am Rande ist die Halbleiterscheibe 2 in üblicher Weise angeschrägt und mit einer Randpassivierung 9 versehen. Die Gateelektrode 5, die im dargestellten Beispiel nicht druckkontaktiert wird, ist zum Schutz mit einer Isolationsschicht 8, z.B. einem Polyimid, überdeckt.

Der direkte Druckkontakt umfasst einen kathodenseitigen Druckkontakt 1 und einen anodenseitigen Druckkontakt 3, in Form von Metallscheiben, die aus Mo- oder W-Blech hergestellt sind. Beide Druckkontakte 1,3 werden von beiden Seiten mit einem ausreichenden Anpressdruck P gegen die Halbleiterscheibe 2 gepresst, um den elektrischen und thermischen Kontakt innerhalb des Bauelements zu gewährleisten.

Mit den Kathodenfingern 7 in Rosettenstruktur ergibt sich ein typisches Verhältnis von Anodenfläche $A_A$ zu Kathodenfläche $A_K$ von

$$2 \; < \; \frac{A_A}{A_K} \; < \; 5$$

Um einen akzeptablen Wärmeübergang sicherzustellen, muss der Druck in der Anodenfläche den bei derartigen Bauelementen üblichen Werten von typischerweise 10....15 MPa entsprechen. Für den Druck auf der Kathodenseite ergibt sich ein entsprechend dem Verhältnis $A_A/A_K$ erhöhter Wert.

Zusätzlich zu dem durch das ungünstige Flächenverhältnis erhöhten Druck muss mit weiteren lokalen Drucküberhöhungen gerechnet werden, nämlich

(a) mit einer ausgeprägten Drucküberhöhung in der Nähe des Druckkontakt-Randes (sog. Stempel-Effekt), und

(b) mit einer Drucküberhöhung im Bereich der Kerben in der Halbleiterscheibe.

Diese mechanischen Beanspruchungen lassen sich für eine vorgegebene Geometrie numerisch berechnen (vgl. z.B. A.C. Zinkiewicz, Y.K. Cheung, "The finite element method in structural and continuum mechanics," Mc Graw-Hill, 1970).

In der Praxis bewirkt die Drucküberhöhung (a) zum Beispiel, dass die Fliessgrenze am Rande der Kathoden-bzw.Anodenschicht 6 bzw. 4 zuerst erreicht wird. Ein derartiges, geringfügiges Fliessen hat jedoch automatisch einen Ausgleich der Drucküberhöhung zur Folge. Drucktechnisch ist daher dieser Fall in der Regel unkritisch, solange sich dadurch die Fläche des metallisierten Bereiches nur unwesentlich vergrössert.

Eine Drucküberhöhung vom Typ (b) führt zu einer Kerbwirkung. Die theoretische Berechnung eines typischen Anwendungsfalles zeigt, dass die lokale mechanische Spannung in der Halbleiterscheibe 2 um einen Faktor grösser als 2 steigt. Diese Zusatzbeanspruchung ist besonders kritisch, da sich hierzu noch die durch thermische Ausdehnung der verschiedenen Materialien induzierten Zug- bzw. Scherspannungen überlagern. Falls die Dicke der mechanisch gepressten Scheibe viel grösser ist, als die laterale Ausdehnung der nicht gepressten Bereiche (im Falle des GTO der Lücken zwischen den Kathodenfingern 7), gleichen sich die Spannungen innerhalb der Scheibe mit zunehmender Distanz von der Kathodenoberfläche vollständig aus. Dieser Effekt ist als Prinzip von Saint-Venant bekannt (vgl. z.B. I. Szabo, "Einführung in die technische Mechanik", 7. Auflage, Springer-Verlag 1966, S. 130). Er ist beim legierten Druckkontakt wirksam, weil Halbleiterscheibe und angelötete Unterlage eine einheitliche Scheibe grösserer Dicke bilden.

Beim direkten Druckkontakt, wo die gepresste Halbleiterscheibe nicht legiert ist, ist obige Bedingung auch nicht erfüllt. Die mechanischen Spannungen sind in der ganzen Halbleiterscheibe inhomogen und können lokal sogar das Vorzeichen wechseln (sog. Filon-Effekt, d.h. örtliches Abheben der gepressten Scheibe auf der ebenen Rückseite). Aus diesem Grunde musste davon ausgegangen werden, dass der direkte Druckkontakt bei der beschriebenen Inselstruktur zur Zerstörung der Halbleiterscheibe führt.

In einer Versuchsreihe, die an GTO-Thyristoren mit direktem Druckkontakt unter extremer Druck- und Temperaturbelastungen durchgeführt worden ist, hat sich nun überraschenderweise herausgestellt, dass der direkte Druckkontakt bei GTOs mit strukturierter Kathodenoberfläche praktikabel ist, wenn bestimmte Massnahmen ergriffen werden.

Wichtig ist dabei zunächst die Planität, d.h. Ebenheit der Flächen von Halbleiterscheibe und Druckkontakten, die miteinander in Kontakt stehen. Die Unebenheiten dieser Flächen, die Planitätsabweichung darf nicht mehr als 5 µm betragen und sollte vorzugsweise unterhalb von 1 µm liegen.

Weiterhin müssen an den Druckkontakten 1 und 3 scharfe Kanten vermieden werden, die, wenn der Druckkontakt innerhalb der Fläche der Halbleiterscheibe endet, zu den bereits beschriebenen Fliessvorgängen führt.

Für den einfachsten Fall einer planaren Anodenseite (siehe die Figur) muss zumindest der anodenseitige Druckkontakt 3 auf der der Halbleiterscheibe 2 zugewandten Seite an seiner Kante facettiert oder abgerundet sein.

Schliesslich müssen die äusseren Begrenzungen der gegenüberliegenden Druckkontakte 1 und 3 innerhalb enger Toleranzen ausgerichtet sein. Ausreichend ist hier, dass die Druckkontakte 1 und 3 in ihren

EP 0 254 910 B1

Mittelachsen um weniger als 500 $\mu$m voneinander abweichen, was bei gleichem Durchmesser einer gleich grossen Radiusdifferenz $\Delta$r (eingezeichnet in der Figur) entspricht.

Bevorzugt wird eine Abweichung von weniger als 100 $\mu$m.

Der Durchmesser des kathodenseitigen Druckkontakts 1 ist so gewählt, dass sein Rand über die Kathodenfinger 7 seitlich hinausragt.

Im einzelnen werden bei der Anordnung die folgenden Abmessungen gewählt:

| | |
|---|---|
| Durchmesser der Druckkontakte | > 20 mm |
| Breite der Kathodenfinger | > 0,1 mm |
| Länge der Kathodenfinger | > 1 mm |
| Grabentiefe zwischen den Kathodenfingern | 5-50 $\mu$m |
| Zahl der Kathodenfinger | $\geq$ 100 |

Für die erwähnten Versuche wurden Halbleiterscheiben mit einem Durchmesser von 48,6 mm und einer Dicke von 350 mm verwendet. Die Druckkontakte aus Mo hatten einen Durchmesser von 44,5 mm und eine Dicke von 2 mm. Der kathodenseitige Druckkontakt hatte in der Mitte ein Loch von 8 mm Durchmesser (siehe auch die Figur).

Die Halbleiterscheiben wurden mit den Druckkontakten jeweils in ein 3-Zoll-Thyristorgehäuse eingebaut und zu je 5 Elementen in eine Säule eingespannt und mit Kräften von 20, bis 40 kN beaufschlagt.

Dies entspricht einem anodenseitigen Druck von 13 bis 27 MPa, während der kathodenseitige Druck - entsprechend der geringeren Fläche - etwa viermal so hoch war.

Die Testelemente wurden ausserdem auf maximal 180°C erwärmt und anschliessend in einem Kaltluftstrom auf Raumtemperatur abgekühlt.

Die Zahl der Temperaturwechsel betrug $\geq$ 20 Zyklen.

In einer zweiten Versuchsreihe wurden Lastwechsel mittels einer Strombelastung der GTO-Bauelemente gefahren, die einen Temperaturhub bis 125° erzeugten (12 000 Lastwechsel; anodenseitiger Druck von ca. 14 MPa).

Es zeigte sich, dass in beiden Fällen die elektrischen Kennwerte der Halbleiterscheibe durch die Versuchsbelastungen nur im Rahmen der Messtoleranz verändert wurden.

Ebenso wurden nur vergleichsweise geringe durch den Druck verursachte Aenderungen in den Anoden- und Kathodenschichten aus Al festgestellt, obwohl die theoretische Fliessgrenze von Al kathodenseitig überschritten worden ist.

Obgleich der erfindungsgemässe direkte Druckkontakt nur am einfachen Beispiel eines GTO mit planarer Anodenseite beschrieben worden ist, kann die Erfindung insbesondere auch bei GTOs angewandt werden, die anodenseitig gleichfalls eine Stufenstruktur aufweisen, was speziell bei GTOs mit doppeltem Gate (kathodenseitig und anodenseitig) der Fall ist.

Insgesamt führen also die erfindungsgemässen Vorkehrungen zu einem GTO-Thyristor mit direktem Druckkontakt, der eine ausgezeichnete Lastwechselfestigkeit aufweist.

**Patentansprüche**

1. Druckkontaktierter GTO-Thyristor, umfassend

(a) eine Halbleiterscheibe (2) mit einer Folge unterschiedlich dotierter Schichten, die zwischen einer Kathodenseite und einer Anodenseite angeordnet sind;

(b) wobei die Halbleiterscheibe (2) zumindest kathodenseitig stufenförmig ausgebildet ist und eine Gate-Kathodenstruktur aufweist mit einer Anzahl von grösser oder ungefähr gleich 100 Kathodenfingern (7) mit einer Breite von jeweils grösser 0,1 mm und einer Länge von jeweils grösser 1 mm, welche Kathodenfinger (7) von einem tieferliegenden Gatebereich umgeben sind, derart, dass die Tiefe der Gräben zwischen den Kathodenfingern (7) zwischen 5 und 50 $\mu$m beträgt;

(c) wobei die Halbleiterscheibe (2) auf den Kathodenfingern (7) jeweils mit einer metallischen Kathodenschicht (6) und anodenseitig mit einer metallischen Anodenschicht (4) belegt ist;

(d) wobei die Halbleiterscheibe (2) ohne Zwischenfügung eines anlegierten Zwischenträgers unmittelbar von beiden Seiten durch angepresste Druckkontakte (1,3) in Form von Molybbän- oder Wolfram-Scheiben druckkontaktiert wird;

(e) wobei die Druckkontakte (1,3) und die Halbleiterscheibe (2) auf ihren einander zugewandten Kontaktflächen eine Planitätsabweichung von weniger als $\pm$ 5 $\mu$m bei einem Durchmesser der Halbleiterscheibe (2) von 20 mm - 100 mm aufweisen;

5

(f) wobei die Druckkontakte (1,3) gegeneinander so ausgerichtet sind, dass die axiale Abweichung ihrer Mittelachsen voneinander weniger als 500 $\mu$m beträgt;

(g) wobei zumindest der anodenseitige Druckkontakt (3) auf der der Halbleiterscheibe (2) zugewandten Seite an seiner Kante facettiert oder abgerundet ist; und

(h) wobei der kathodenseitige Druckkontakt (1) einen so grossen Durchmesser aufweist, dass sein Rand über die Kathodenfinger (7) hinausragt.

2.  Druckkontaktierter GTO-Thyristor nach Anspruch 1, dadurch gekennzeichnet, dass die Anodenseite planar ist.

3.  Druckkontaktierte GTO-Thyristor nach Anspruch 2, dadurch gekennzeichnet, dass die Planitätsabweichung der Druckkontakte (1,3) und der Halbleiterscheibe (2) weniger als ± 1 $\mu$m beträgt.

4.  Druckkontaktierter GTO-Thyristor nach Anspruch 3, dadurch gekennzeichnet, dass die axiale Abweichung der Mittelachsen der Druckkontakte (1,3) weniger als 100 $\mu$m beträgt.

5.  Druckkontaktierter GTO-Thyristor nach Anspruch 1, dadurch gekennzeichnet, dass der Durchmesser der Druckkontakte (1,3) grösser als 20 mm ist.

**Claims**

1.  Pressure-bonded GTO thyristor comprising

    (a) a semiconductor wafer (2) with a sequence of differently doped layers which are arranged between a cathode side and an anode side;

    (b) the semiconductor wafer (2) being of step-shaped design at least on the cathode side and having a gate-cathode structure with a number of greater than or approximately equal to 100 cathode fingers (7) having a width of in each case greater than 0.1 mm and a length of in each case greater than 1 mm, which cathode fingers (7) are surrounded by a lower-lying gate region, in such a manner that the depth of the trenches between the cathode fingers (7) is between 5 and 50 $\mu$m;

    (c) the semiconductor wafer (2) being covered in each case with a metallic cathode layer (6) on the cathode fingers (7) and with a metallic anode layer (4) on the anode side;

    (d) the semiconductor wafer (2) being directly pressure-bonded from both sides by pressure contacts (1, 3) in the form of molybdenum or tungsten discs pressed on without interposition of an alloyed-on intermediate carrier;

    (e) the pressure contacts (1, 3) and the semiconductor wafer (2) exhibiting on their contact surfaces facing one another a deviation from planarity of less than ± 5 $\mu$m with a diameter of the semiconductor wafer (2) of 20 mm - 100 mm;

    (f) the pressure contacts (1, 3) being aligned with respect to one another in such a manner that the axial deviation of their centre axes from one another is less than 500 $\mu$m;

    (g) at least the anode-side pressure contact (3) being facetted or rounded at its edge on the side facing the semiconductor wafer (2); and

    (h) the cathode-side pressure contact (1) having a diameter which is so large that its edge projects past the cathode fingers (7).

2.  Pressure-bonded GTO thyristor according to Claim 1, characterised in that the anode side is planar.

3.  Pressure-bonded GO thyristor according to Claim 2, characterised in that the deviation from planarity of the pressure contacts (1, 3) and of the semiconductor wafer (2) is less than ± 1 $\mu$m.

4.  Pressure-bonded GTO thyristor according to Claim 3, characterised in that the axial deviation of the centre axes of the pressure contacts (1, 3) is less than 100 $\mu$m.

5.  Pressure-bonded GTO thyristor according to Claim 1, characterised in that the diameter of the pressure contacts (1, 3) is greater than 20 mm.

**Revendications**

1.  Thyristor GTO à contacts à pression, comprenant :

(a) un disque semi-conducteur (2) présentant une succession de couches à dopages différents, qui sont disposées entre un côté cathodique et un côté anodique;

(b) le disque semi-conducteur (2) étant d'une conception étagée, au moins du côté cathodique, et présentant une structure de gâchette-cathode comportant un nombre de doigts de cathode (7) supérieur ou environ égal à 100, chacun d'une largeur supérieure à 0,1 mm et d'une longueur supérieure à 1 mm, ces doigts de cathode (7) étant entourés par un domaine de gâchette situé en contrebas de sorte que la profondeur des fosses entre les doigts de cathode (7) est comprise entre 5 et 50 $\mu$m;

(c) le disque semi-conducteur (2) étant garni, sur les doigts de cathode (7) chaque fois d'une couche de cathode métallique (6) et, du côté anodique, d'une couche d'anode métallique (4);

(d) le disque semi-conducteur (2) étant mis en contact par pression, sans intercalation d'un support intermédiaire fixé par alliage, directement des deux côtés par des contacts à pression (1, 3) pressés en place qui ont la forme de disques de molybdène ou de tungstène;

(e) les contacts à pression (1, 3) et le disque semi-conducteur (2) présentant, sur leurs surfaces de contact tournées l'une vers l'autre, un écart de planéité de moins de ± 5 $\mu$m pour un diamètre du disque semi-conducteur (2) de 20 mm à 100 mm;

(f) les contacts à pression (1, 3) étant alignés l'un par rapport à l'autre de telle façon que l'écart axial de leurs axes centraux soit inférieur à 500 $\mu$m;

(g) au moins le contact à pression (3) du côté anodique présentant, sur son côté tourné vers le disque semi-conducteur (2), une facette ou un arrondi en lieu et place de son arête; et

(h) le contact à pression du côté cathodique (1) présentant un si grand diamètre que son bord s'étend au-delà des doigts de cathode (7).

2. Thyristor GTO à contacts à pression suivant la revendication 1, caractérisé en ce que le côté anodique est plat.

3. Thyristor GTO à contacts à pression suivant la revendication 2, caractérisé en ce que l'écart de planéité des contacts à pression (1, 3) et du disque semi-conducteur (2) est inférieur à ± 1 $\mu$m.

4. Thyristor GTO à contacts à pression suivant la revendication 3, caractérisé en ce que l'écart axial des axes centraux des contacts à pression (1, 3) est inférieur à 100 $\mu$m.

5. Thyristor GTO à contacts à pression suivant la revendication 1, caractérisé en ce que le diamètre des contacts à pression (1, 3) est superieur à 20 mm.